Europäisches Patentamt

European Patent Office

Office européen des brevets

(19)

(11) EP 0 635 946 B1

(12) **FASCICULE DE BREVET EUROPEEN**

(45) Date de publication et mention
de la délivrance du brevet:
**30.09.1998 Bulletin 1998/40**

(51) Int Cl.$^6$: **H03M 3/02**

(21) Numéro de dépôt: **94401587.4**

(22) Date de dépôt: **08.07.1994**

(54) **Convertisseur analogique numérique à boucle de contre réaction modulée**

AD-Wandler mit modulierten Rückkopplungsschleife

Analog to digital converter with modulated feedback

(84) Etats contractants désignés:
**AT BE CH DE DK ES FR GB IT LI NL SE**

(30) Priorité: **13.07.1993 FR 9308625**

(43) Date de publication de la demande:
**25.01.1995 Bulletin 1995/04**

(73) Titulaire: **ALCATEL ALSTHOM COMPAGNIE GENERALE D'ELECTRICITE**
**75008 Paris (FR)**

(72) Inventeurs:
- **Azrouf, Sabrina, c/o CNAM**
  **F-75141 Paris Cedex 03 (FR)**
- **Bellanger, Maurice, c/o CNAM**
  **F-75141 Paris Cedex 03 (FR)**
- **Bruneau, Vincent, c/o Mr de Fay**
  **F-92707 Colombes Cedex (FR)**

- **Gourgue, Frédéric,**
  **F-75017 Paris (FR)**

(74) Mandataire: **Renaud-Goud, Thierry et al**
**c/o ALCATEL ALSTHOM,**
**Département de Propriété Industrielle,**
**30, avenue Kléber**
**75116 Paris (FR)**

(56) Documents cités:
**EP-A- 0 399 738**

- **SIGNAL PROCESSING. EUROPEAN JOURNAL DEVOTED TO THE METHODS AND APPLICATIONS OF SIGNAL PROCESSING, vol.22, no.2, Février 1991, AMSTERDAM NL, XP000208672 H.-J. DRESSLER 'Interpolative Bandpass - A/D - Conversion'**

## Description

La présente invention concerne un convertisseur analogique numérique à boucle de contre-réaction modulée.

Le domaine de l'invention est celui de la conversion d'un signal d'entrée analogique en un signal de sortie numérique dans le cas plus précis où ce signal de sortie doit présenter une haute résolution ou bien lorsque le signal d'entrée présente une grande dynamique.

Dans ce domaine particulier, figurent notamment les systèmes de radiocommunications où le signal d'entrée d'un récepteur peut varier dans une large mesure, de l'ordre de 100 dB ou même plus.

Il est ainsi connu d'utiliser pour la conversion d'un signal d'entrée en bande de base un convertisseur de type sigma-delta. Ses principaux avantages sont les suivants :

- il a une faible sensibilité aux imperfections des composants,
- il peut être aisément intégré dans un circuit,
- il a une consommation plus faible que ces homologues (convertisseurs flashs) à performances égales,
- il présente une bonne linéarité pour des résolutions importantes.

Le convertisseur sigma-delta est fréquemment pourvu d'une fonction de filtrage passe-bas. Ainsi, pour un signal d'entrée occupant une largeur de bande B autour d'une fréquence centrale $f_0$, il faut que le filtre passe-bas ait une fréquence de coupure au moins égale à $f_0 + B/2$. On sait que lorsque l'on augmente la fréquence de coupure, on augmente le coût du composant en conséquence. De plus, pour une fréquence d'échantillonnage $f_e$ déterminée du convertisseur, si l'on augmente la fréquence de coupure, on dégrade le rapport signal sur bruit.

Afin d'améliorer cette situation, on a prévu de remplacer la fonction de filtrage passe-bas par une fonction de filtrage passe-bande. Cette solution est notamment exposée dans l'ouvrage de J.H. DRESSLER : "Interpolative Bandpass A/D Conversion", Signal Processing, Elsevier Science Publishers B.V., 22, pp. 139-151, 1991.

On choisit en général d'adopter comme fréquence centrale du filtre passe-bande la fréquence centrale $f_0$ de la largeur de bande du signal d'entrée. Il se produit alors une atténuation en sinx/x par rapport au convertisseur sigma-delta pourvu d'un filtre passe-bas où x prend la valeur $\pi.f_0/f_e$, ce qui sera explicité par la suite. Il s'ensuit que plus la fréquence centrale $f_0$ du filtre passe-bande est élevée, plus l'atténuation est importante. Naturellement, une augmentation de l'atténuation entraîne une dégradation du rapport signal sur bruit.

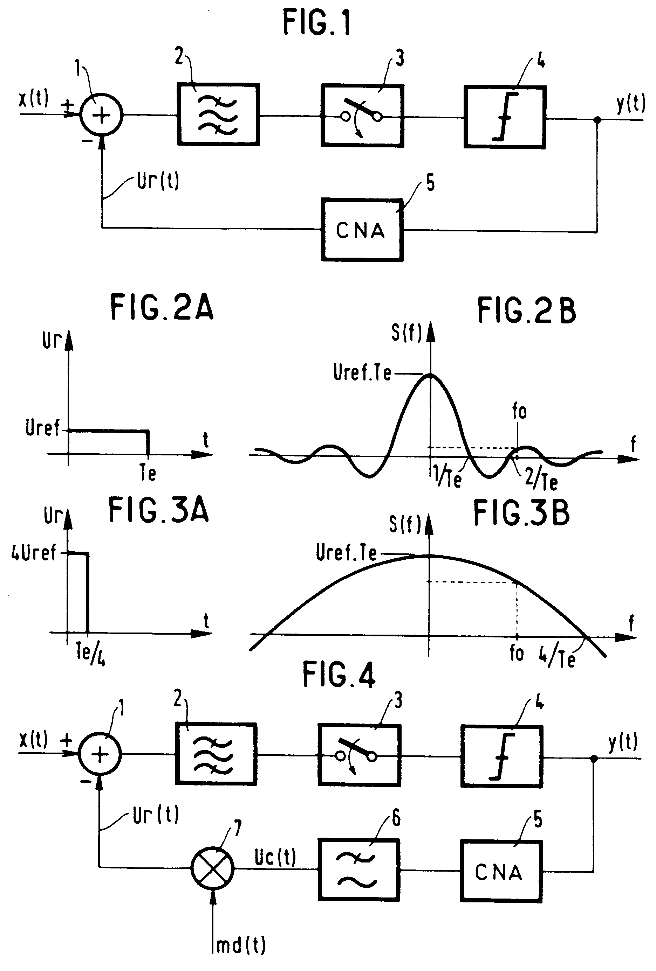

Il existe une solution pour limiter ce phénomène, mais pour l'exposer, il convient auparavant de décrire brièvement le fonctionnement du convertisseur sigma-delta en référence à la figure 1. Celui-ci comprend un soustracteur 1 qui reçoit un signal d'entrée x(t) et un signal de référence Ur(t) pour en faire la différence. Il comprend ensuite un filtre 2 qui reçoit le signal de sortie du soustracteur 1 pour produire un signal filtré, un échantillonneur 3 qui reçoit ce signal filtré et produit des échantillons, et un quantificateur 4 qui délivre un signal d'écart numérique y(t) à partir de ces échantillons. Le convertisseur comprend également une boucle de contre-réaction. Cette boucle comporte un convertisseur numérique analogique 5 qui produit le signal de référence Ur(t) à partir du signal d'écart y(t). Par ailleurs, on admet ici, à titre d'exemple, que le quantificateur 4 produit un signal sur deux niveaux, c'est-à-dire qu'il se réduit à un comparateur.

Le phénomène d'atténuation évoqué ci-dessus est particulièrement marqué lorsque la fréquence d'échantillonnage $f_e$ est inférieure à la fréquence centrale $f_0$. En effet, le signal de référence Ur(t) d'amplitude maximale Uref est susceptible de changer de valeur au même rythme que le signal d'écart y(t), c'est-à-dire à chaque période d'échantillonnage Te où Te vaut évidemment l'inverse de la fréquence d'échantillonage $f_e$. Une impulsion en sortie du convertisseur numérique analogique 5 présente ainsi une amplitude Uref pendant une durée Te, comme représenté à la figure 2A. La transformée de Fourier S(f) de la réponse impulsionnelle, ou réponse fréquentielle, représentée dans la figure 2B est de la forme sinx/x déjà évoquée du fait que ce convertisseur 5 a une fonction de filtrage passe-bas. Si la fréquence centrale $f_0$ vaut par exemple 2,25 fois la fréquence d'échantillonnage $f_e$, il apparaît que l'atténuation est très importante.

La solution connue consiste à réduire la largeur de l'impulsion pour se rapprocher du cas idéal de l'impulsion de Dirac. Cependant, il faut augmenter l'amplitude de l'impulsion pour conserver une aire constante qui vaut Uref.Te. A titre d'exemple, on peut diviser la durée de l'impulsion par 4 et multiplier son amplitude par 4, comme représenté dans la figure 3A. La transformée de Fourier S(f) de la réponse impulsionnelle, ou réponse fréquentielle, est représentée dans la figure 3B. On a bien réduit l'atténuation mais celle-ci est encore relativement élevée.

De plus, le fait d'augmenter l'amplitude du signal de référence n'est pas souhaitable pour deux raisons au moins. La première est qu'il faut disposer d'une alimentation d'énergie permettant de le faire. Ce n'est pas toujours le cas, surtout si l'accroissement d'amplitude souhaité est important. La seconde raison est liée au temps de montée tant du convertisseur numérique analogique 5 que de l'étage d'entrée correspondant du soustracteur 1. Si le signal de référence Ur(t) devrait en théorie présenter une pente d(Ur)/dt infinie, ce n'est pas le cas dans la pratique où cette pente a une valeur fixée k. Ainsi, le retard entre un changement de valeur du signal d'écart y(t) et la prise en compte globale de ce changement dans le signal de sortie du soustracteur sera d'autant plus important que l'amplitude du signal de référence est élevée. Il peut même arriver que l'impulsion théorique souhaitée ait un rapport amplitude sur durée qui soit supérieur à cette valeur k, si bien que l'impulsion réelle n'atteindra jamais l'amplitude souhaitée. Il va sans dire que les performances du convertisseur sigma-delta s'en trouvent sérieusement dégradées.

Il apparaît donc que la solution qui consiste à modifier la forme de l'impulsion n'apporte pas de réponse définitive au problème posé.

La présente invention a ainsi pour but un convertisseur analogique numérique bien adapté au traitement d'un signal occupant une bande de fréquences B inférieure à sa fréquence centrale $f_0$.

Le convertisseur analogique numérique reçoit un signal d'entrée analogique pour produire un signal d'écart numérique. Il comprend un soustracteur pour faire la différence du signal d'entrée et d'un signal de référence, une chaîne de conversion pour produire ce signal d'écart à partir de cette différence et une boucle de contre-réaction pour produire le signal de référence au moyen d'un convertisseur numérique analogique qui délivre un signal de comparaison en réponse au signal d'écart. Selon l'invention, le signal d'entrée étant affecté d'une fréquence centrale, la boucle de contre-réaction comprend de plus un organe de déplacement pour déplacer la réponse fréquentielle du convertisseur numérique analogique de la fréquence nulle vers la fréquence centrale, cet organe de déplacement produisant le signal de référence à partir du signal de comparaison.

Dans un mode de réalisation avantageux du convertisseur analogique numérique, l'organe de déplacement est un modulateur produisant le signal de référence par modulation du signal de comparaison au moyen d'un signal modulant.

On obtient ainsi un moyen commode de parvenir au résultat souhaité, à savoir une diminution de l'atténuation et, par conséquent, une amélioration des performances du convertisseur analogique numérique.

Selon une première option, on peut prévoir que le signal modulant présente une composante spectrale à une fréquence de modulation égale à la fréquence centrale.

Par ailleurs, suivant une solution simple, le signal de référence est le produit du signal de comparaison et du signal modulant.

L'invention s'applique naturellement lorsque la chaîne de conversion comprend un échantillonneur travaillant à une fréquence d'échantillonnage, de sorte que le signal d'écart garde une valeur constante durant une période d'échantillonnage.

Ainsi, selon une seconde option, le signal modulant présente une composante spectrale à une fréquence de modulation égale à un multiple de la moitié de cette fréquence d'échantillonnage.

On prévoit de plus que le signal modulant a une valeur positive à la fin de chacune des périodes d'échantillonnages.

En outre, la chaîne de conversion comprend un filtre passe-bande centré sur la fréquence centrale et un quantificateur.

Avantageusement, ce quantificateur est un comparateur.

En tout état de cause, on peut ajouter un filtre passe-bas entre le convertisseur numérique analogique et l'organe de déplacement.

L'invention apparaîtra maintenant de manière plus précise dans le cadre de la description qui suit en référence aux figures annexées qui représentent :

- la figure 1, un convertisseur analogique numérique de l'état de l'art,
- les figures 2A et 2B, respectivement une impulsion calibrée et la transformée de Fourier de la réponse impulsionnelle d'un élément de ce convertisseur selon un premier mode de réalisation connu,
- les figures 3A et 3B, respectivement une impulsion calibrée et la transformée de Fourier de la réponse impulsionnelle d'un élément de ce convertisseur selon un second mode de réalisation connu,
- la figure 4, un exemple d'un convertisseur analogique numérique selon l'invention,
- la figure 5, la forme du signal de comparaison et du signal modulant mis en oeuvre dans ce convertisseur,
- la figure 6, un schéma de la réponse impulsionnelle de la boucle de contre-réaction de ce convertisseur,
- la figure 7, un diagramme du module de la fonction de transfert de cette boucle,
- la figure 8, un diagramme du module de la fonction de transfert d'un élément de cette boucle.

Les éléments présents dans différentes figures seront affectés d'une seule référence.

Les convertisseurs sigma-delta sont généralement pourvus de deux fonctions principales : la conversion proprement dite et un traitement numérique comprenant notamment une opération de filtrage et de décimation. L'invention concerne la conversion proprement dite, c'est-à dire l'ensemble des organes qui permettent d'obtenir le signal d'écart à la sortie du quantificateur. C'est pourquoi on considèrera dorénavant, par un abus de langage, que le convertisseur analogique numérique correspond à ces seuls organes.

L'invention se propose de pallier au phénomène d'atténuation présenté plus haut et schématisé sur la figure 2B.

On prévoit pour ce faire de déplacer le lobe principal de la réponse fréquentielle qui est la transformée de Fourier S(f) de la réponse impulsionnelle de la fréquence f = 0 vers la fréquence centrale $f_0$ au moyen d'un organe de déplacement.

De manière connue, en référence à la figure 4, le convertisseur sigma-delta comprend un soustracteur 1 qui reçoit un signal d'entrée x(t) et un signal de référence Ur(t) pour en faire la différence. Il comprend ensuite un filtre passe-bande 2 qui reçoit le signal de sortie du soustracteur 1 pour produire un signal filtré, un échantillonneur 3 qui reçoit ce signal filtré et produit des échantillons, et un quantificateur 4 qui délivre un signal d'écart numérique y(t) à partir de ces échantillons. On admet ici, à titre d'exemple, que le quantificateur 4 produit un signal sur deux niveaux, c'est-à-dire qu'il se réduit à un comparateur. L'ensemble constitué par le filtre 2, l'échantillonneur 3 et le quantificateur 4 assure une fonction bien connue de l'homme du métier et l'on conviendra de le nommer chaine de conversion.

Le convertisseur sigma-delta comprend également une boucle de contre-réaction. Cette boucle comporte un convertisseur numérique analogique 5 qui produit un signal de comparaison Uc(t) à partir du signal d'écart y(t).

Selon l'invention, la boucle de contre-réaction comprend l'organe de déplacement qui produit le signal de référence Ur(t) à partir du signal de comparaison Uc(t).

A titre optionnel, on peut prévoir un filtre passe-bas 6 à la sortie du convertisseur numérique analogique 5. La fonction de ce filtre sera explicitée par la suite.

On va maintenant décrire un exemple de réalisation de cet organe de déplacement : il s'agit dun modulateur (7) qui produit le signal de référence Ur(t) par modulation du signal de comparaison Uc(t) filtré ou non filtré au moyen d'un signal modulant md(t).

Dans l'exemple adopté ici, l'opération de modulation est une multiplication de sorte que le signal de référence Ur(t) vaut le produit du signal de comparaison Uc(t) et du signal modulant md(t).

Cette modulation a pour objet de modifier la réponse fréquentielle du convertisseur numérique analogique 5.

Le signal modulant md(t) peut être sinusoïdal, auquel cas le filtre passe-bas 6 présente un intérêt plus limité. Cependant, il peut être plus commode de choisir un signal carré, afin de faciliter la réalisation du modulateur 7, par exemple.

Dans ce dernier cas, le modulateur 7 va déplacer vers la fréquence du signal modulant md(t) qu'on nomme fréquence de modulation $f_m$ :

- le lobe principal de S(f) suite à l'effet de la composante fondamentale du signal modulant,
- des lobes secondaires suite au produit des harmoniques de ce signal modulant et des lobes secondaires de S(f).

Ces lobes secondaires peuvent être considérés comme un bruit. C'est ici que le filtre passe-bas 6 prend tout son intérêt, pour éliminer ce bruit indésirable.

On choisit donc ce signal modulant md(t) pour qu'il ait une composante spectrale à la fréquence de modulation $f_m$ proche de la fréquence centrale $f_0$. Dans l'idéal, il conviendrait que ces deux fréquences soient égales, mais il peut être plus commode d'adopter des valeurs différentes ne serait-ce que pour des raisons technologiques.

En effet, compte-tenu du fait qu'il est déjà prévu un générateur d'horloge pour produire la fréquence d'échantilonnage $f_e$, une solution avantageuse consiste à choisir la fréquence de modulation $f_m$ comme un multiple de la moitié de cette fréquence d'échantillonnage :

$$f_m = m.f_e/2$$

où m est un nombre entier,

$$T = 1/f_m.$$

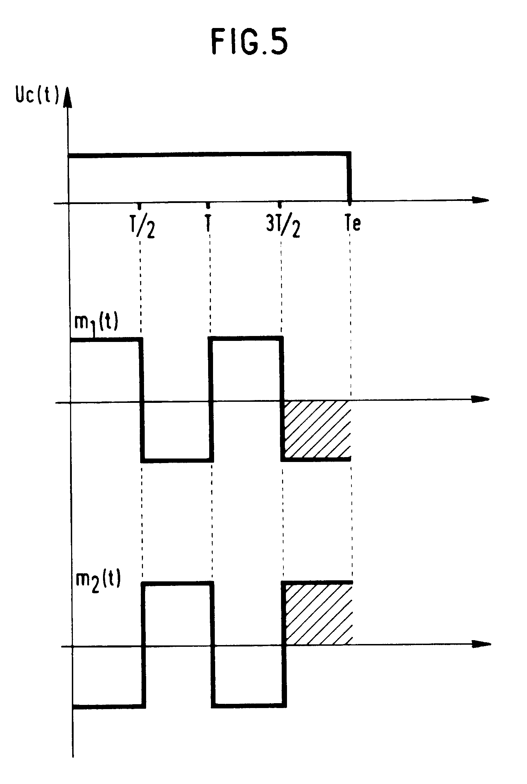

La phase de md(t) est importante pour la stabilité du convertisseur sigma-delta. Cependant, l'ambiguïté de la phase pour les cas m>0 est simple à lever, comme cela a été abordé par J.H. DRESSLER dans l'ouvrage déjà cité. Le signal md(t) est considéré synchrone de la fréquence d'échantillonnage fe. Deux cas sont à envisager comme indiqué dans la figure 5 où l'on a choisi m = 4 à titre d'exemple.

On a représenté le signal de comparaison Uc(t) et deux formes possibles du signal modulant :

- la première $m_1(t)$ où ce signal est en phase avec le signal de comparaison,
- la seconde $m_2(t)$ où ce signal est en opposition de phase avec le signal de comparaison.

Dans la première forme du signal modulant $m_1(t)$, il apparait une contre-réaction positive à la fin de la période d'échantillonnage, c'est-à-dire entre 3T/2 et Te dans le cas présent. Ce phénomène peut provoquer une oscillation du convertisseur sigma-delta. Une solution avantageuse consiste à choisir la seconde forme $m_2(t)$ du signal modulant pour éviter tout risque d'instabilité. En fin de compte, le signal modulant doit toujours avoir une valeur positive à la fin d'une période d'échantillonnage, c'est-à-dire lors d'un possible changement de valeur du signal de comparaison Uc(t).

On rappellera maintenant l'expression connue de la fonction de transfert G(p) d'un filtre passe-bas d'ordre 2 :

$$G(p) = a_0 \cdot \left[ \frac{1}{p} + \frac{\alpha}{p^2} \right]$$

On peut convertir ce filtre passe-bas pour obtenir le filtre passe-bande 2 du convertisseur sigma-delta par le biais d'une transformation X(p), par exemple :

$$X(p) = \frac{B.p}{p^2 + B.p + \omega_0^2} \ ,$$

où B représente la bande passante et $\omega_0$ la pulsation centrale.

L'expression du filtre passe-bande F(p) correspondant d'ordre 4 devient donc :

$$F(p) = a_0 \cdot \frac{Bp(p^2 + (1+\alpha)Bp + \omega_0^2)}{(p^2 + Bp + \omega_0^2)^2} \tag{1}$$

Le coefficient $\alpha$ et le gain $a_0$ sont déterminés afin d'optimiser la réjection du bruit, tout en garantissant la stabilité du convertisseur sigma-delta.

Par ailleurs, l'ensemble du convertisseur numérique analogique 5 et du modulateur a pour réponse impulsionnelle h(t).

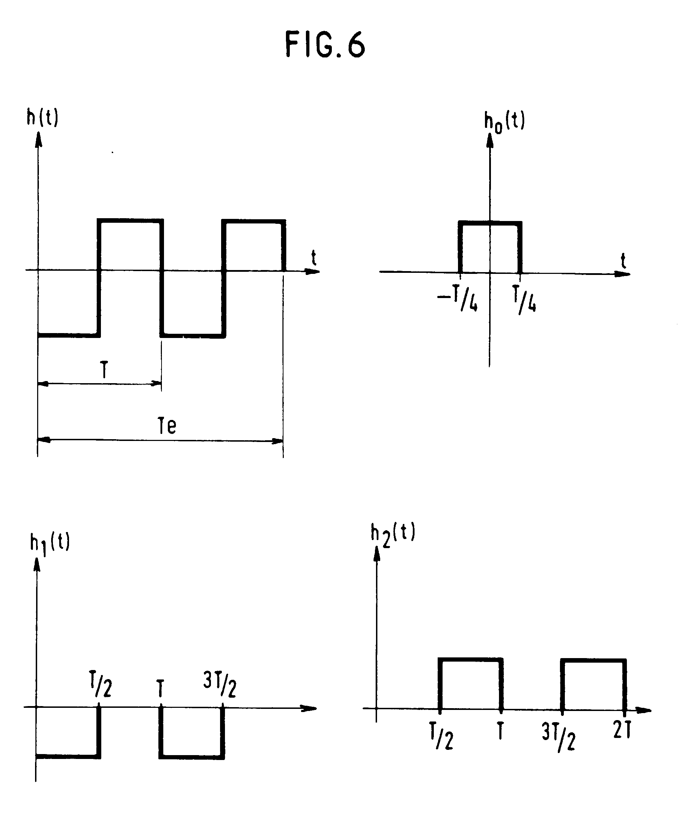

On adopte les notations suivantes en référence à la figure 6 :

- $h_0(t)$ est un signal élémentaire qui correspond à une impulsion de durée T/2 centrée sur l'origine des temps,
- $h_1(t)$ est un premier signal de combinaison qui correspond aux impulsions négatives de h(t), et
- $h_2(t)$ est un second signal de combinaison qui correspond aux impulsions positives de h(t).

Par convention, H($\omega$), $H_0(\omega)$, $H_1(\omega)$, $H_2(\omega)$ représentent les transformées de Fourier des fonctions respectives h(t), $h_0(t)$, $h_1(t)$, $h_2(t)$.

On peut alors écrire :

$$N = Te/T = m/2$$

$$h(t) = h_1(t) + h_2(t)$$

$$H_1(\omega) = -H_0(\omega) \cdot \left( e^{\frac{-j\omega T}{4}} + e^{\frac{-5j\omega T}{4}} + e^{\frac{-9j\omega T}{4}} + \ldots \right)$$

$$H_1(\omega) = -H_0(\omega) \cdot \sum_{n=0}^{N-1} e^{\frac{-j\omega(4n+1)T}{4}}$$

$$H_2(\omega) = +H_0(\omega).\left(e^{\frac{-3j\omega T}{4}} + e^{\frac{-7j\omega T}{4}} + e^{\frac{-11j\omega T}{4}} + \ldots\right)$$

$$H_2(\omega) = +H_0(\omega) \cdot \sum_{n=0}^{N-1} e^{\frac{-j\omega(4n+3)T}{4}}$$

$$H(\omega) = H_1(\omega) + H_2(\omega)$$

$$H(\omega) = +H_0(\omega).\sum_{n=0}^{2N-1}(-1)^{(n+1)}e^{\frac{-j\omega(2n+1)T}{4}} \qquad (2)$$

où,

$$H_0(\omega) = \frac{T}{2} \cdot \frac{\sin\frac{\omega T}{4}}{\frac{\omega T}{4}}$$

On donne l'application numérique suivante en matière d'exemple :

| - Bande passante | B | 30 KHz |
|---|---|---|
| - Fréquence centrale | $f_0$ | 10,6 MHz |
| - Fréquence d'échantillonnage | $f_e$ | 4,71 MHz |
| - Fréquence du signal modulant | $f_m$ | 9,42 MHz |
| - Rapport $f_m / (f_e/2)$ | m | 4 |
| - Ordre du filtre passe-bande | R | 2 |
| - Amplitude du signal de référence | Uref | 1 V |

L'expression du filtre passe-bande F(p) a été déterminée en utilisant la formule (1). Son expression est obtenue en prenant $a_0 = 1$ et $\alpha = 0.5$.

La fonction de transfert de l'ensemble du convertisseur numérique analogique 5 et du modulateur 7 a pour expression, selon la formule (2) :

$$H(\omega) = +H_0(\omega).\sum_{n=0}^{3}(-1)^{(n+1)}e^{\frac{-j\omega(2n+1)T}{4}}$$

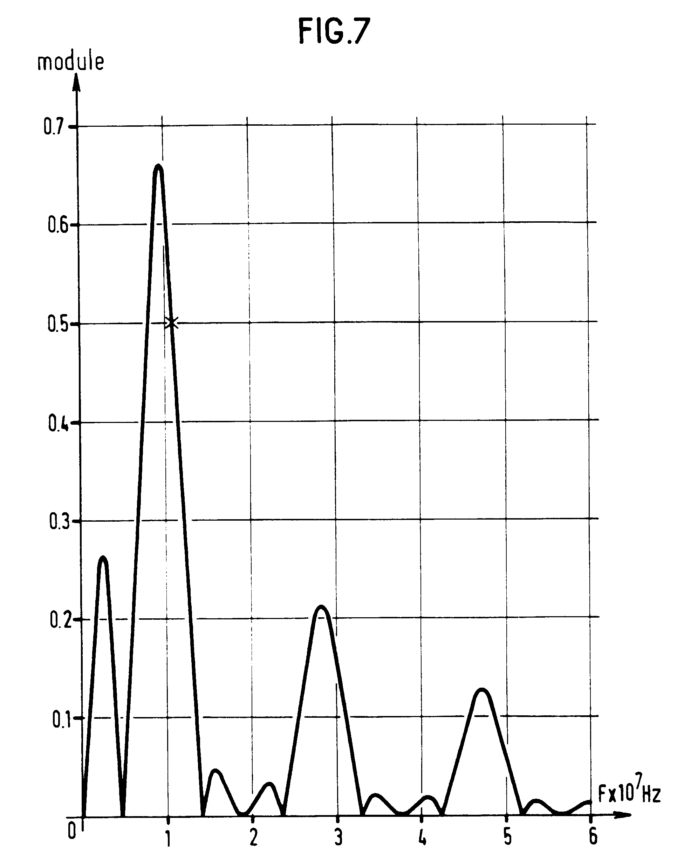

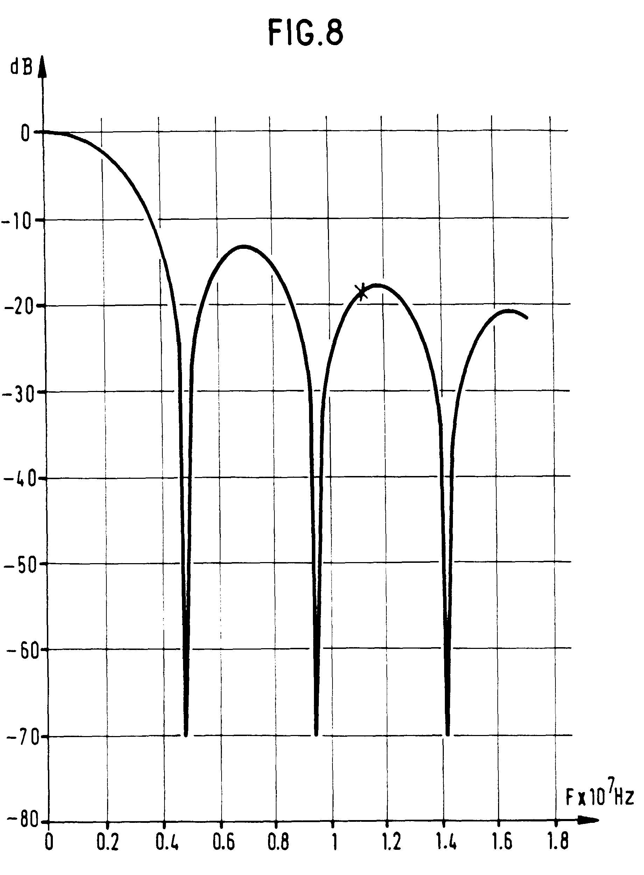

Le module de H($\omega$) est représenté dans la figure 7. Le module de la fonction de transfert du convertisseur numérique analogique 5 est représenté dans la figure 8. Le convertisseur de l'invention produit ainsi une atténuation de 6dB au lieu de 20 dB environ en l'absence de modulateur.

**Revendications**

1. Convertisseur analogique numérique recevant un signal d'entrée analogique (x(t)) pour produire un signal d'écart numérique (y(t)), comprenant un soustracteur (1) pour faire la différence dudit signal d'entrée et d'un signal de référence (Ur(t)), une chaîne de conversion (2, 3, 4) pour produire ledit signal d'écart à partir de cette différence

## EP 0 635 946 B1

et une boucle de contre-réaction pour produire ledit signal de référence au moyen d'un convertisseur numérique analogique (5) qui délivre un signal de comparaison (Uc(t)) en réponse audit signal d'écart, caractérisé en ce que, ledit signal d'entrée (x(t)) étant affecté d'une fréquence centrale ($f_0$), ladite boucle de contre-réaction comprend un organe de déplacement (7) pour déplacer la réponse fréquentielle dudit convertisseur numérique analogique (5) de la fréquence nulle vers ladite fréquence centrale ($f_0$), cet organe de déplacement produisant ledit signal de référence (Ur(t)) à partir dudit signal de comparaison (Uc(t)).

2. Convertisseur analogique numérique selon la revendication 1, caractérisé en ce que ledit organe de déplacement est un modulateur (7) produisant ledit signal de référence (Ur(t)) par modulation dudit signal de comparaison (Uc(t)) au moyen d'un signal modulant (md(t)).

3. Convertisseur analogique numérique selon la revendication 2 caractérisé en ce que, ledit signal modulant (md(t)) présente une composante spectrale à une fréquence de modulation ($f_m$) égale à ladite fréquence centrale ($f_0$).

4. Convertisseur analogique numérique selon la revendication 2, caractérisé en ce que ledit signal de référence (Ur(t)) est le produit dudit signal de comparaison (Uc(t)) et dudit signal modulant (md(t)).

5. Convertisseur analogique numérique selon la revendication 4, caractérisé en ce que ladite chaîne de conversion comprend un échantillonneur (3) travaillant à une fréquence d'échantillonnage ($f_e$), de sorte que ledit signal d'écart (y(t)) garde une valeur constante durant une période d'échantillonnage ($T_e$).

6. Convertisseur analogique numérique selon la revendication 5, caractérisé en ce que ledit signal modulant (md(t)) présente une composante spectrale à une fréquence de modulation ($f_m$) égale à un multiple de la moitié de cette fréquence d'échantillonnage ($f_e$).

7. Convertisseur analogique numérique selon la revendication 5 caractérisé en ce que, ledit signal modulant (md(t)) a une valeur positive à la fin de chacune desdites périodes d'échantillonnages.

8. Convertisseur analogique numérique selon la revendication 5, caractérisé en ce que ladite chaîne de conversion comprend un filtre passe-bande (2) centré sur ladite fréquence centrale ($f_0$).

9. Convertisseur analogique numérique selon la revendication 5, caractérisé en ce que ladite chaîne de conversion comprend un quantificateur (4).

10. Convertisseur analogique numérique selon la revendication 9, caractérisé en ce que ledit quantificateur (4) est un comparateur.

11. Convertisseur analogique numérique selon l'une quelconque des revendications précédentes, caractérisé en ce qu'il comprend un filtre passe-bas (6) disposé entre ledit convertisseur numérique analogique (5) et ledit organe de déplacement (7).


**Patentansprüche**

1. Analog-Digital-Wandler, der ein analoges Eingangssignal (x(t)) empfängt, um ein digitales Abweichungssignal (y(t)) zu erzeugen, umfassend einen Subtrahierer (1) zum Bilden der Differenz des Eingangssignals und eines Referenzsignals (Ur(t)), eine Umwandlungskette (2, 3, 4) zum Erzeugen des Abweichungssignals aus dieser Differenz und eine Rückkopplungsschleife zum Erzeugen des Referenzsignals mit Hilfe eines Digital-Analog-Wandlers (5), der ein Vergleichssignal (Uc(t)) in Reaktion auf das Abweichungssignal abgibt, dadurch gekennzeichnet, daß, wobei dem Eingangssignal (x(t)) eine Mittenfrequenz ($f_0$) zugewiesen ist, die Rückkopplungsschleife ein Verschiebungsorgan (7) zum Verschieben der Frequenzantwort des Digital-Analog-Wandlers (5) von der Nullfrequenz zu der Mittenfrequenz ($f_0$) umfaßt, wobei dieses Verschiebungsorgan das Referenzsignal (Ur(t)) aus dem Vergleichssignal (Uc(t)) erzeugt.

2. Analog-Digital-Wandler nach Anspruch 1, dadurch gekennzeichnet, daß das Verschiebungsorgan ein Modulator (7) ist, der das Referenzsignal (Ur(t)) durch Modulation des Vergleichssignals (Uc(t)) mit Hilfe eines modulierenden Signals (md(t)) erzeugt.

7

**3.** Analog-Digital-Wandler nach Anspruch 2, dadurch gekennzeichnet, daß das modulierende Signal (md(t)) eine Spektralkomponente bei einer Modulationsfrequenz ($f_m$) gleich der Mittenfrequenz ($f_0$) aufweist.

**4.** Analog-Digital-Wandler nach Anspruch 2, dadurch gekennzeichnet, daß das Referenzsignal (Ur(t)) das Produkt des Vergleichssignals (Uc(t)) und des modulierenden Signals (md(t)) ist.

**5.** Analog-Digital-Wandler nach Anspruch 4, dadurch gekennzeichnet, daß die Umslandlungskette einen Abtaster (3) umfaßt, der bei einer Abtastfrequenz ($f_e$) arbeitet, derart, daß das Abweichungssignal (y(t)) während einer Abtastperiode ($T_e$) einen konstanten Wert beibehält.

**6.** Analog-Digital-Wandler nach Anspruch 5, dadurch gekennzeichnet, daß das modulierende Signal (md(t)) eine Spektralkomponente bei einer Modulationsfrequenz ($f_m$) gleich einem Mehrfachen der Hälfte dieser Abtastfrequenz ($f_e$) aufweist.

**7.** Analog-Digital-Wandler nach Anspruch 5, dadurch gekennzeichnet, daß das modulierende Signal (md(t)) einen positiven Wert am Ende jeder der Abtastperioden hat.

**8.** Analog-Digital-Wandler nach Anspruch 5, dadurch gekennzeichnet, daß die Umwandlungskette einen auf die Mittenfrequenz ($f_0$) zentrierten Bandpaßfilter (2) umfaßt.

**9.** Analog-Digital-Wandler nach Anspruch 5, dadurch gekennzeichnet, daß die Umwandlungskette einen Zuordner (4) umfaßt.

**10.** Analog-Digital-Wandler nach Anspruch 9, dadurch gekennzeichnet, daß der Zuordner (4) ein Komparator ist.

**11.** Analog-Digital-Wandler nach einem der vorhergehenden Ansprüche, dadurch gekennzeichnet, daß er einen Tiefpaßfilter (6) umfaßt, der zwischen dem Digital-Analog-Wandler (5) und dem Verschiebungsorgan (7) angeordnet ist.

## Claims

**1.** Analogue-to-digital converter receiving an analogue input signal (x(t)) to produce a digital error signal (y(t)) comprising a subtractor (1) to calculate the difference between said input signal and a reference signal (Ur(t)), a converter subsystem (2, 3, 4) to produce said error signal from said difference and a feedback loop to produce said reference signal by means of a digital-to-analogue converter (5) which delivers a comparison signal (Uc(t)) in response to said error signal, characterised in that, said input signal (x(t)) being assigned a centre frequency ($f_0$), said feedback loop comprises a displacement unit (7) for displacing the frequency response of said digital-to-analogue converter (5) from the null frequency towards said centre frequency ($f_0$), said displacement unit producing said reference signal (Ur(t)) from said comparison signal (Uc(t)).

**2.** Analogue-to-digital converter according to claim 1 characterised in that said displacement unit is a modulator (7) producing said reference signal (Ur(t)) by modulating said comparison signal (Uc(t)) by means of a modulating signal (md(t)).

**3.** Analogue-to-digital converter according to claim 2 characterised in that said modulating signal (md(t)) has a spectral component at a modulation frequency ($f_m$) equal to said centre frequency ($f_0$).

**4.** Analogue-to-digital converter according to claim 2 characterised in that said reference signal (Ur(t)) is the product of said comparison signal (Uc(t)) and said modulating signal (md(t)).

**5.** Analogue-to-digital converter according to claim 4 characterised in that said converter subsystem comprises a sampler (3) operating at a sampling frequency ($f_e$) whereby said error signal (y(t)) retains a constant value during a sampling period ($T_e$).

**6.** Analogue-to-digital converter according to claim 5 characterised in that said modulating signal (md(t)) has a spectral component at a modulation frequency ($f_m$) equal to a multiple of half said sampling frequency ($f_e$).

7. Analogue-to-digital converter according to claim 5 characterised in that said modulating signal (md(t)) has a positive value at the end of each sampling period.

8. Analogue-to-digital converter according to claim 5 characterised in that said converter subsystem comprises a bandpass filter (2) centred on said centre frequency ($f_0$).

9. Analogue-to-digital converter according to claim 5 characterised in that said converter subsystem comprises a quantizer (4).

10. Analogue-to-digital converter according to claim 9 characterised in that said quantizer (4) is a comparator.

11. Analogue-to-digital converter according to any one of the preceding claims characterised in that it comprises a lowpass filter (6) between said digital-to-analogue converter (5) and said displacement unit (7).

## FIG.1

## FIG.2A

## FIG.2B

## FIG.3A

## FIG.3B

## FIG.4

# FIG.5

# FIG.6

# FIG.7

# FIG.8